# EUROPEAN PATENT APPLICATION

(11) **EP 2 693 839 A1**
(43) Date of publication of application: **05.02.2014**
(21) Application number: 12763529.0
(22) Date of filing: 30.03.2012
(51) Int. Cl.: H05B 33/02, H01L 51/50, H05B 33/10

(54) **ORGANIC LED ELEMENT, LIGHT-TRANSMITTING SUBSTRATE, AND METHOD FOR PRODUCING LIGHT-TRANSMITTING SUBSTRATE**

(30) Priority: 31.03.2011 JP 2011080716
(71) Applicant: Asahi Glass Company, Limited, Tokyo 100-8405 (JP); AGC Glass Europe SA, 1170 Bruxelles (Watermael-Boitsfort) (BE)
(72) Inventor: TANIDA, Masamichi, Tokyo 100-8405 (JP); NAKAMURA, Nobuhiro, Tokyo 100-8405 (JP); WADA, Naoya, Tokyo 100-8405 (JP); AOKI, Yumiko, Tokyo 100-8405 (JP); DOMERCQ, Benoit, 1170 Bruxelles(Watermael-Boitsfort) (BE)
(74) Representative: Müller-Boré & Partner Patentanwälte PartG mbB
(86) International application number: PCT/JP2012/058699
(87) International publication number: WO 2012/133832

(57) **Abstract**

An organic LED element includes a transparent substrate; a light scattering layer formed on the transparent substrate; a transparent first electrode formed on the light scattering layer; an organic light emitting layer formed on the first electrode; and a second electrode formed on the organic light emitting layer, wherein the light scattering layer includes a base material made of glass, and a plurality of scattering substances dispersed in the base material, and wherein a coating layer, which is not a molten glass, is provided between the light scattering layer and the first electrode.

## Description

### BACKGROUND OF THE INVENTION

### 1. Field of the Invention

The present invention relates to an organic LED element, a translucent substrate and a method of manufacturing a translucent substrate.

### 2. Description of the Related Art

Organic Light Emitting Diode (LED) elements are widely used for displays, backlights, illuminations and the like.

A general purpose organic EL element includes a first electrode (anode) and a second electrode (cathode) provided on substrates, respectively, and an organic light emitting layer provided between these electrodes. When applying a voltage between the electrodes, holes and electrons are injected into the organic light emitting layer from the corresponding electrodes. When the holes and the electrons are recombined in the organic light emitting layer, a binding energy is generated to excite organic luminescent materials in the organic light emitting layer. As light emissions occur when the excited luminescent materials return to the ground state, a luminescent (LED) element is obtained by using this phenomenon.

Generally, a transparent thin layer such as Indium Tin Oxide (which will be simply referred to as "ITO" hereinafter) is used for the first electrode, the anode in other words, and a metal thin layer such as aluminum, silver or the like is used for the second electrode, the cathode in other words.

Recently, a technique has been disclosed in which a concavoconvex surface for scattering light is formed at a surface of a glass plate on which an ITO electrode is to be formed, and a sintered glass layer is formed on the concavoconvex surface to form a glass substrate (Patent Document 1).

According to this method, it is disclosed that a part of the light generated at the organic light emitting layer is scattered by a concavoconvex interface between the glass plate and the sintered glass layer so that the amount of the light trapped in the organic LED element (the amount of total reflection) is reduced to increase the light extracting efficiency from the organic LED element.

### [Patent Document]

[Patent Document 1] Japanese Laid-open Patent Publication No. 2010-198797

The sintered glass layer disclosed in Patent Document 1 is formed by sintering glass paste. However, there may be often a case that contaminants remain at a surface of such a sintered glass layer after formation.

When such contaminants exist at the surface of the sintered glass layer, there may be a problem that layers are not appropriately deposited in subsequent film deposition processes of the electrodes, the organic light emitting layer or the like composing the organic LED element. In particular, there may be a problem that the contaminant causes shading in the subsequent film deposition processes based on the shape of the remaining contaminant so that a deposition material cannot reach a deposition surface in a desired manner. For example, an organic light emitting layer, which is to be positioned between two electrodes, may not be deposited so that there is a high danger that the two electrodes become electrically connected and shorted. In such a case, the finally obtained organic LED element cannot have desired characteristics.

Patent Document 1 discloses that a protection layer having a thickness about 50 nm may be formed on the sintered glass layer by sputtering. However, it is difficult to appropriately cover the contaminants remaining at the surface of the sintered glass layer by the protection layer having such a small thickness (for example, the grain diameter of the contaminant may be as large as 10 µm at the maximum). Therefore, such a protection layer cannot be used for solving the above described problem.

### SUMMARY OF THE INVENTION

The present invention is made in light of the above problems, and provides an organic LED element in which problems in depositing films such as shorting of electrodes or the like hardly occurs. Further, the present invention provides a translucent substrate used for such an organic LED element and a method of manufacturing such a translucent substrate.

According to an embodiment, there is provided an organic LED element including a transparent substrate; a light scattering layer formed on the transparent substrate; a transparent first electrode formed on the light scattering layer; an organic light emitting layer formed on the first electrode; and a second electrode formed on the organic light emitting layer, wherein the light scattering layer includes a base material made of glass, and a plurality of scattering substances dispersed in the base material, and wherein a coating layer, which is not a molten glass, is provided between the light scattering layer and the first electrode.

In the organic LED element of the embodiment, the coating layer may include at least one selected from a group including titanium oxide, niobium oxide, zirconium oxide, and tantalum oxide.

Such a coating layer may further include silicon oxide. For example, the coating layer may be a mixed layer of titanium oxide and silicon oxide.

In the organic LED element of the embodiment, the coating layer may have a thickness range of 100 nm to 500 nm.

In the organic LED element of the embodiment, the scattering substances may be bubbles, deposited crystals of the glass composing the base material and/or refractory fillers.

According to another embodiment, there is provided a translucent substrate including a transparent substrate; and a light scattering layer formed on the transparent substrate, wherein the light scattering layer includes a base material made of glass, and a plurality of scattering substances dispersed in the base material, and wherein a coating layer, which is not a molten glass, is provided on the light scattering layer.

In the translucent substrate of the embodiment, the coating layer may include at least one selected from a group including titanium oxide, niobium oxide, zirconium oxide, and tantalum oxide.

Such a coating layer may further include silicon oxide. For example, the coating layer may be a mixed layer of titanium oxide and silicon oxide.

In the translucent substrate of the embodiment, the coating layer may have a thickness range of 100 nm to 500 nm.

In the translucent substrate of the embodiment, the scattering substances may be bubbles, deposited crystals of the glass composing the base material and/or refractory fillers.

According to another embodiment, there is provided a method of manufacturing a translucent substrate including a transparent substrate and a light scattering layer, including: a step (a) of forming the light scattering layer on the transparent substrate, the light scattering layer including a base material made of glass, and a plurality of scattering substances dispersed in the base material; and a step (b) of providing a coating layer, which is not a molten glass, on the light scattering layer by wet-coating.

In the method of the embodiment, the step (b) may include a step (b1) of providing sol-gel liquid of an organic metal solution and/or an organic metal particle on the light scattering layer, and a step (b2) of forming a coating layer by heating the sol-gel liquid.

The method of the embodiment may include a step (b3) of drying the sol-gel liquid between the steps (b1) and (b2).

In the method of the embodiment, the organic metal solution and/or the organic metal particle included in the sol-gel liquid may include at least one element selected from a group including titanium, niobium, zirconium, and tantalum.

Further, the sol-gel liquid may further include silicon oxide.

Further, for example, the coating layer may be a mixed layer of titanium oxide and silicon oxide.

In the method of the embodiment, the step (b2) may be performed within a temperature range of 450 °C to 550 °C.

According to another embodiment, there is provided a substrate for an organic LED including: a light scattering layer formed on a transparent substrate; and a coating layer directly formed on the light scattering layer, wherein the coating layer includes a titanium compound and/or a silicide compound.

According to another embodiment, there is provided a substrate for an organic LED including: a light scattering layer formed on a transparent substrate; a functional layer directly formed on the light scattering layer; and a coating layer directly formed on the functional layer, wherein the coating layer includes a titanium compound and/or a silicide compound.

In the substrate for an organic LED of the embodiment, the functional layer may be glass including phosphorus (P).

Alternatively, the functional layer may be glass without phosphorus (P).

In the substrate for an organic LED of the embodiment, the functional layer may be an inorganic layer.

Alternatively, in the substrate for an organic LED of the embodiment, the functional layer may be an organic layer.

Alternatively, in the substrate for an organic LED of the embodiment, the functional layer may be a hybrid layer of an organic material and an inorganic material.

Further, in the substrate for an organic LED of the embodiment, the titanium compound and the silicide compound may be manufactured from a source material including alkoxy group.

Further, in the substrate for an organic LED of the embodiment, the source material may include alkoxysilane or silazane including at most three reactive functional groups, each of which becomes a Si-O-Si bonding structure by sintering.

Further, in the substrate for an organic LED of the embodiment, the source material may include an organic silicon compound including at most three reactive functional groups, which is one of alkoxy, hydroxy, hydro and amino per Si atom.

According to the embodiment, an organic LED element can be provided in which problems in depositing films such as shorting of electrodes or the like hardly occurs. Further, a translucent substrate used for such an organic LED element and a method of manufacturing such a translucent substrate can be provided.

### BRIEF DESCRIPTION OF THE DRAWINGS

Fig. 1 is a schematic cross-sectional view illustrating an organic LED element of a related art;
Fig. 2A to Fig. 2D are schematic views for explaining a problem that occurs in manufacturing an organic LED element of an related art;
Fig. 3 is a schematic cross-sectional view illustrating an example of an organic LED element of an embodiment;
Fig. 4 is a schematic cross-sectional view illustrating a part of a coating layer of the organic LED element of the embodiment; and
Fig. 5 is a schematic flowchart illustrating an example of a method of manufacturing the organic LED element of the embodiment.

### DETAILED DESCRIPTION OF THE PREFERRED EMBODIMENTS

The invention will be described herein with reference to illustrative embodiments.

### (Organic LED element of related art)

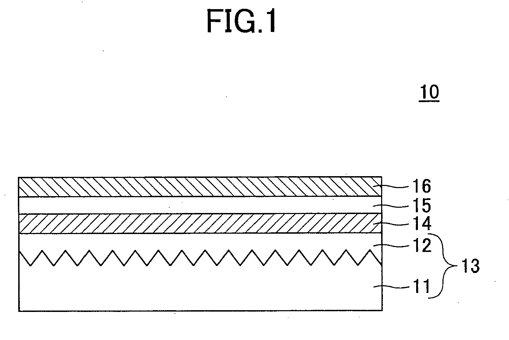

Before describing of the present invention, a structure of an organic LED element of a related art such as disclosed in Patent Document 1 is explained in detail with reference to Fig. 1 in order to facilitate the understanding of the present invention. Fig. 1 is a schematic cross-sectional view illustrating an organic LED element of a related art.

As shown in Fig. 1, an organic LED element 10 of a related art is configured by stacking a glass substrate 13, a transparent electrode (anode) 14, an organic light emitting layer 15 and a second electrode (cathode) 16 in this order. The glass substrate 13 is composed of a glass plate 11, which has a concavoconvex surface, and a sintered glass layer 12 formed on the concavoconvex surface of the glass substrate 11.

For the example illustrated in Fig. 1, a lower surface of the organic LED element 10 (in other words, an exposed surface of the glass substrate 13) becomes a light extraction surface.

The light generated in the organic light emitting layer 15 is effectively scattered at the concavoconvex surface of the glass substrate 13. Thus, with the organic LED element 10 having such a structure, the light extracting efficiency from the light extraction surface of the organic LED element 10 can be further increased compared with a structure without the concavoconvex surface.

The sintered glass layer 12 can be obtained by sintering glass paste. However, in general, there may often be a case that contaminants included in glass material or the like remain at the surface of the sintered glass layer 12. The larger contaminant has a size about a diameter of 10 µm.

When such contaminants exist at the surface of the sintered glass layer 12, there may be a case that layers are not appropriately deposited in subsequent film deposition processes of the transparent electrode 14, the organic light emitting layer 15 and the second electrode 16.

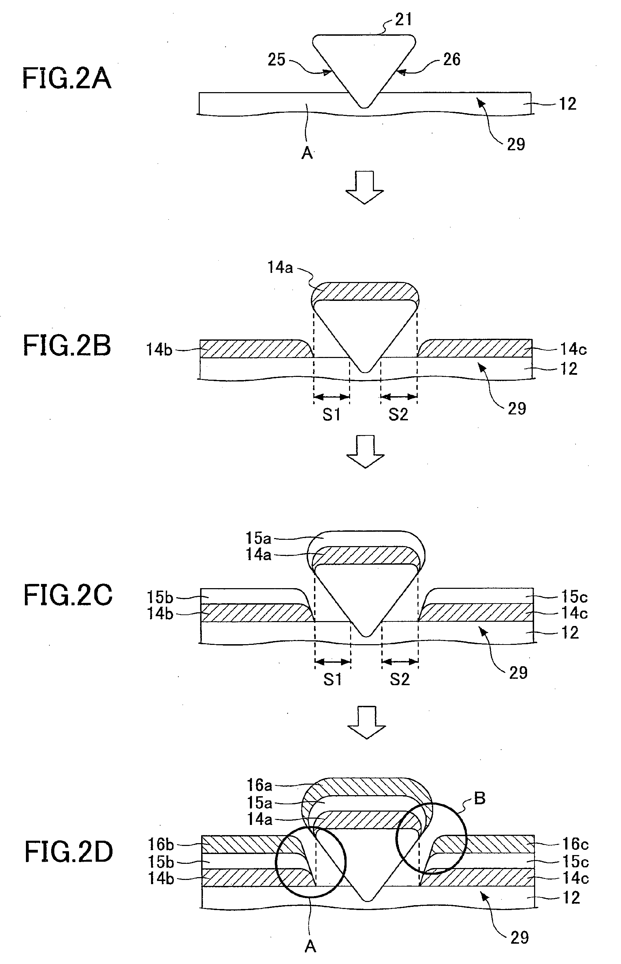

Fig. 2A to Fig. 2D are schematic views illustrating changes in layer structures when forming the transparent electrode, the organic light emitting layer and the second electrode in this order, under a state in which a contaminant exists at the surface of the sintered glass layer 12.

As shown in Fig. 2A, there exists a contaminant 21 at the surface 29 of the sintered glass layer 12. The contaminant 21 is provided with a first side surface 25 and a second side surface 26. The first side surface 25 is formed such that the grain diameter of the contaminant 21 decreases from an upper side to a lower side. Similarly, the second side surface 26 is formed such that the grain diameter of the contaminant 21 decreases from the upper side to the lower side.

Under this state, when a film deposition material is deposited on the surface of the sintered glass layer 12 in order to deposit the transparent electrode 14, as shown in Fig. 2B, the film deposition material is deposited above the contaminant 21 to form a layer portion 14a and also deposited above the surface 29 of the sintered glass layer 12 to form layer portions 14b and 14c.

Here, due to the existence of the first side surface 25 of the contaminant 21, the film deposition material is hardly deposited at an area S1 of the surface 29 of the sintered glass layer 12. Thus, as shown in Fig. 2B, the layer portion 14b is formed in a state that it does not completely cover the area S1 of the surface 29 of the sintered glass layer 12. Similarly, due to the existence of the second side surface 26 of the contaminant 21, the film deposition material is hardly deposited at an area S2 of the surface 29 of the sintered glass layer 12. Thus, as shown in Fig. 2B, the layer portion 14c is formed in a state that it does not completely cover the area S2 of the surface 29 of the sintered glass layer 12.

Next, when a film deposition material is deposited on the surface of the transparent electrode 14 in order to deposit the organic light emitting layer 15, as shown in Fig. 2C, the film deposition material is deposited on the layer portions 14a, 14b and 14c of the transparent electrode 14, respectively. As a result, layer portions 15a, 15b and 15c of the organic light emitting layer 15 are formed.

For this case as well, due to the contaminant 21, the layer portions 15b and 15c are hardly formed above the areas S1 and S2 of the surface 29 of the sintered glass layer 12. In particular, the layer portion 15a of the organic light emitting layer 15 tends to completely cover the layer portion 14a of the transparent electrode 14 to be extended at side portions of the layer portion 14a. Then, this layer portion 15a causes shading when depositing the film deposition material of the organic light emitting layer 15. Therefore, formation areas of the layer portions 15b and 15c become smaller than those of the layer portions 14b and 14c of the transparent electrode 14.

Next, when a film deposition material is deposited above the organic light emitting layer 15 in order to deposit the second electrode 16, as shown in Fig. 2D, the film deposition material is formed on the layer portions 15a, 15b and 15c of the organic light emitting layer 15, respectively. As a result, layer portions 16a, 16b and 16c of the second electrode 16 are formed.

For this case as well, due to the contaminant 21, the layer portions 16b and 16c are hardly formed above the areas S1 and S2 of the surface 29 of the sintered glass layer 12. In particular, the layer portion 16a of the second electrode 16 tends to completely cover the layer portion 15a of the organic light emitting layer 15 to be extended at side portions of the layer portion 15a. Then, this layer portion 16a causes shading when depositing the film deposition material of the second electrode 16. Therefore, formation areas of the layer portions 16b and 16c become smaller than those of the layer portion 15b and 15c of the organic light emitting layer 15.

In such layer structures, there is a high possibility that the layer portion 14b of the transparent electrode 14 and the layer portion 16b of the second electrode 16 make contact at a portion surrounded by a circle A in Fig. 2D. Similarly, there is a high possibility that the layer portion 14a of the transparent electrode 14 and the layer portion 16c of the second electrode 16 make contact at a portion surrounded by a circle B in Fig. 2D.

As such, due to the existence of the contaminant 21 on the sintered glass layer 12, there may be a case that the layers are not appropriately deposited in subsequent film deposition processes of the transparent electrode 14, the organic light emitting layer 15 and the second electrode 16. Further, when this influence becomes large, there may be caused a problem that two electrodes short. Further, if such a short occurs, the finally obtained organic LED element cannot have desired characteristics.

Above described Patent Document 1 discloses that a protection layer having a thickness about 50 nm is formed between the sintered glass layer 12 and the transparent electrode 14 by sputtering.

However, this protection layer is not provided to solve the problem of the above described contaminant 21. For example, even when the protection layer is provided above the sintered glass layer 12, it is difficult to solve the above described problem with the protection layer whose thickness is as small as about 50 nm.

### (Organic LED element of embodiment)

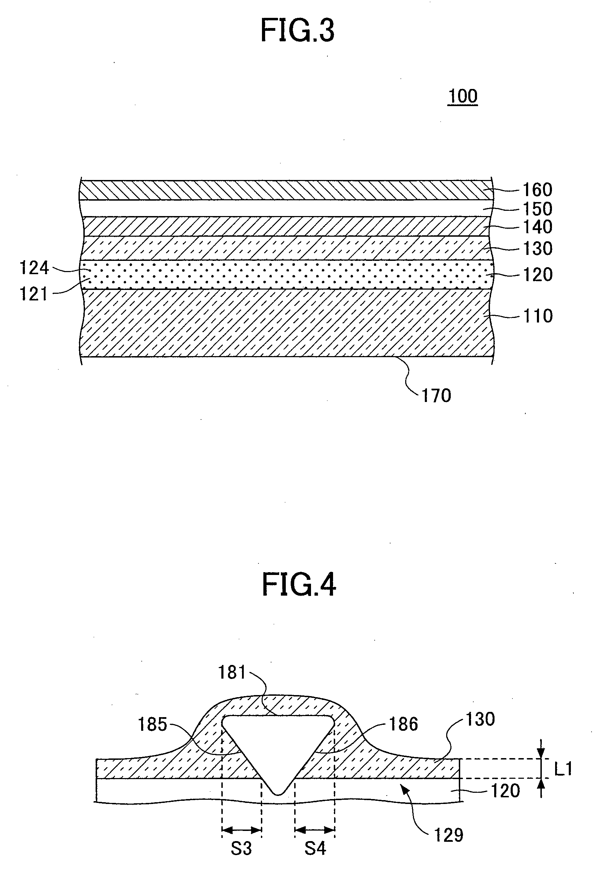

An example of a structure of an organic LED element of the embodiment is explained with reference to Fig. 3. Fig. 3 is a schematic cross-sectional view illustrating an example of the organic LED element of the embodiment.

As shown in Fig. 3, the organic LED element 100 of the embodiment is configured by stacking a transparent substrate 110, a light scattering layer 120, a coating layer 130, a first electrode (anode) 140, an organic light emitting layer 150 and a second electrode (cathode) 160 in this order.

The transparent substrate 110 has a function to support layers composing the organic LED element provided above.

The light scattering layer 120 is composed of a base material 121 made of glass and having a first refraction index, and a plurality of scattering substances 124 dispersed in the base material 121 and having a second refraction index that is different from that of the base material 121. The thickness of the light scattering layer 120 is within a range of 5 µm to 50 µm, for example.

The first electrode 140 is made of a transparent metal oxide thin film such as Indium Tin Oxide (ITO), for example, the thickness of which is about 50 nm to 1.0 µm. The second electrode 160 is made of a metal such as aluminum or silver, for example.

The organic light emitting layer 150 is, generally, composed of a plurality of layers such as an electron transport layer, an electron injection layer, a hole transport layer, a hole injection layer or the like in addition to a light emitting layer.

For the case illustrated in Fig. 3, a surface of the organic LED element 100 at a lower side (in other words, an exposed surface of the transparent substrate 110) becomes a light extraction surface 170.

The light scattering layer 120 has a function to effectively scatter the light generated in the organic light emitting layer 150 to reduce the amount of the light that is totally reflected in the organic LED element 100. Thus, the organic LED element 100 having the structure illustrated in Fig. 3 is capable of improving the amount of the light emitted from the light extraction surface 170.

Here, in the organic LED element 100 of the embodiment, the coating layer 130 is provided between the light scattering layer 120 and the first electrode 140.

The coating layer 130 functions as a layer that adjusts layer statuses of the subsequent first electrode 140 to the second electrode 160 to be appropriate, even when contaminants exist on the light scattering layer 120.

Fig. 4 is a schematic view illustrating an example of the coating layer 130 when a contaminant exists at the surface of the scattering layer 120.

As shown in Fig. 4, a contaminant 181, having the same form as that illustrated in Figs. 2A to 2D, exists at a surface 129 of the scattering layer 120. Thus, there are areas S3 and S4, which become shaded by first and second side surfaces 185 and 186 of the contaminant 181, at the surface 129 of the scattering layer 120. However, in Fig. 4, the coating layer 130 is formed above the surface 129 of the scattering layer 120 that covers the contaminant 181 and further covers the areas S3 and S4 of the surface 129 of the scattering layer 120.

When the first electrode 140 to the second electrode 160 layers are formed on the coating layer 130 in this order, each of the layers is formed in a form that is continuous and relatively smooth.

Thus, due to the existence of the coating layer 130, in the organic LED element 100 of the embodiment, it is possible to significantly suppress the problem of inappropriate deposition of layers, and in particular, the danger of shorting between the first and second electrodes 140 and 160, which may occur due to the contaminant 181.

Such a coating layer 130 can be relatively easily formed by wet-coating a layer material on the surface 129 of the scattering layer 120, and fixing the material as a layer, for example. For example, the coating layer 130 may be formed by coating sol-gel liquid including a coating layer material on the surface of the transparent substrate 110 including the scattering layer 120, and drying and heating the material.

According to the wet-coating, different from a dry process such as sputtering, the film deposition material can be sufficiently provided to the areas S3 and S4, which had become shaded by the contaminant 181. Thus, the coating layer 130 having the form as illustrated in Fig. 4 can be obtained by using the wet-coating.

Next, each of the layers composing the organic LED element 100 of the embodiment is explained in detail.

### (Transparent substrate 110)

The transparent substrate 110 is made of a material having high transmittance of visible light. The transparent substrate 110 may be, for example, a glass substrate, a plastic substrate or the like.

For the material of the glass substrate, an inorganic glass such as alkali glass, non-alkali glass (alkali-free glass), quartz glass or the like may be exemplified. For the material of the plastic substrate, polyester, polycarbonate, polyether, polysulfone, polyether sulfone, polyvinyl alcohol, a fluorine-containing polymer such as polyvinylidene fluoride, polyvinyl fluoride or the like may be exemplified.

The thickness of the transparent substrate 110 is not particularly limited but may be, for example, within a range of 0.1 mm to 2.0 mm. When considering the strength and the weight, the thickness of the transparent substrate 110 may be, 0.5 mm to 1.4 mm.

### (Light scattering layer 120)

The scattering layer 120 includes the base material 121 and the plurality of scattering substances 124 dispersed in the base material 121. The base material 121 has the first refraction index, and the scattering substances 124 have the second refraction index that is different from that of the base material.

The amount of the scattering substances 124 in the light scattering layer 120 preferably becomes smaller from the inside of the light scattering layer 120 to the outside of the light scattering layer 120, and at this time, light extracting efficiency can be increased.

The base material 121 is made of glass. For the material of the glass, an inorganic glass such as soda-lime glass, borosilicate glass, non-alkali glass (alkali-free glass), quartz glass or the like may be used.

The scattering substances 124 may be made of, for example, pores of a material (bubbles), precipitated crystals, particles of a material different from the base material, phase separated glass or the like. Phase separated glass means a glass composed of two or more kinds of glass phases.

It is preferable that the difference between the refraction indexes of the base material 121 and the scattering substances 124 is large. For this reason, it is preferable that a high refraction index glass is used for the base material 121 and pores of a material are used for the scattering substances 124.

For the high refraction index glass used for the base material 121, one or more components may be selected from P₂O₅, SiO₂, B₂O₃, GeO₂ and TeO₂ as a network former and one or more components may be selected from TiO₂, Nb₂O₅, WO₃, Bi₂O₃, La₂O₃, Gd₂O₃, Y₂O₃, ZrO₂, ZnO, BaO, PbO and Sb₂O₃ as a high refraction index component. Further in order to adjust characteristics of the glass, an alkali oxide, an alkaline earth oxide, a fluoride or the like may be added within a range not impairing characteristics for the refraction index.

Thus, for the glass system composing the base material 121, for example, a B₂O₃-ZnO-La₂O₃ system, a P₂O₅-B₂O₃-R'₂O-R"O-TiO₂-Nb₂O₅-WO₃-Bi₂O₃ system, a TeO₂-ZnO system, a B₂O₃-Bi₂O₃ system, a SiO₂-Bi₂O₃ system, a SiO₂-ZnO system, a B₂O₃-ZnO system, a P₂O₅-ZnO system or the like is exemplified. Here, R' represents an alkali metal element and R" represents an alkaline earth metal element. The above material systems are examples and the materials to be used are not limited as long as satisfying the above-mentioned conditions.

By adding a colorant in the base material 121, color of light emission can be changed. For the colorant, a transition metal oxide, a rare earth metal oxide, a metal colloid or the like may be used singly or in combination thereof.

### (Coating layer 130)

The material of the coating layer 130 is not particularly limited, but the coating layer 130 may include ceramics such as titanium oxide, niobium oxide, zirconium oxide, tantalum oxide or the like, for example.

Further, in addition to the above described ceramics, the coating layer 130 may further include silicon oxide (SiO₂).

For example, the coating layer 130 may be a layer composed of a mixture of titanium oxide and silicon oxide. For this case, the ratio of titanium oxide and silicon oxide is not particularly limited, but the ratio of them (titanium oxide: silicon oxide) may be within a range of 80:20 to 20:80, by weight ratio, for example. In particular, the ratio of titanium oxide: silicon oxide is preferably within a range of 75:25 to 40:60, by weight ratio.

The refraction index of the coating layer 130 is preferably lower than that of the electrode 140 in order to improve the light extracting efficiency. Specifically, the difference between the refraction index of the coating layer 130 and the refraction index of the light scattering layer 120 is preferably 0.2 or less, more preferably 0.13 or less and furthermore preferably 0.11 or less.

When a material, having a resistance against etching solution that is used in an etching process of the first electrode 140, is used as the material of the coating layer 130, a problem that the light scattering layer 120 and the coating layer 130 are damaged in a patterning process of the first electrode 140 can be suppressed.

Thus, it is not necessary to select the material of the light scattering layer 120 from materials having a resistance against the etching solution so that the material of the light scattering layer 120 can be selected from a wider range. The entirety of the above described oxide materials have a resistance against the etching solution (for example, hydrochloric acid system solution including ferric chloride or the like) generally used in the etching process of the first electrode 140.

The thickness of the coating layer 130 is not particularly limited. The thickness of the coating layer 130 may be, for example, within a range of 100 nm to 500 µm. Here, the coating layer 130 is formed by the wet-coating according to the embodiment. Thus, according to the embodiment, different from the dry process such as sputtering, a relatively thick layer can be easily formed by repeating the wet-coating process.

### (First electrode 140)

It is required for the first electrode 140 to have a translucency more than or equal to 80% for extracting the light generated in the organic light emitting layer 150 outside. Further, it is required for the first electrode 140 to have a high work function in order to inject a large number of holes.

For the first electrode 140, a material such as ITO, SnO₂, ZnO, Indium Zinc Oxide (IZO), ZnO-Al₂O₃ (AZO: aluminum doped zinc oxide), ZnO-Ga₂O₃ (GZO: gallium doped zinc oxide), Nb doped TiO₂, Ta doped TiO₂ or the like may be used, for example.

The thickness of the first electrode 140 is preferably more than or equal to 100 nm.

The refraction index of the first electrode 140 is within a range of 1.75 to 2.2. For example, when ITO is used for the first electrode 140, it is possible to reduce the refraction index of the first electrode 140 by increasing the carrier concentration. Although the standard commercially available ITO includes 10 wt % of SnO₂ the refraction index of ITO can be reduced by further increasing the Sn concentration. However, note that although the carrier concentration is increased by increasing the Sn concentration, mobility and transmittance are lowered. Thus, it is necessary to determine the amount of Sn considering the total balance.

Further, it is preferable to determine the refraction index of the first electrode 140 considering the refraction index of the base material 121 composing the light scattering layer 120 or the refraction index of the second electrode 160. It is preferable that the difference between the refraction indexes of the first electrode 140 and the base material 121 is less than or equal to 0.2 considering a calculation of waveguide, a reflectance of the second electrode 160 or the like.

Refraction indexes of the components from the light scattering layer 120 to the first electrode 140 are described for reference. However, the following combination of the refraction indexes is just an example and the components may have different refraction indexes, respectively.

The refraction index of the light scattering layer 120 is, for example, within a range of 1.8 to 2.0(about 1.84, for example). The refraction index of the coating layer 130 is, for example, within a range of 1.7 to 2.0 (about 1.75, for example). The refraction index of the first electrode 140 is, for example, within a range of 1.8 to 2.2 (about 1.8, for example).

### (Organic light emitting layer 150)

The organic light emitting layer 150 has a function to emit light, and generally, includes a hole injection layer, a hole transport layer, a light emitting layer, an electron transport layer and an electron injection layer. Here, as long as the organic light emitting layer 150 includes the light emitting layer, it is not necessary to include all of the other layers. Generally, the refraction index of the organic light emitting layer 150 is within a range of 1.7 to 1.8.

It is preferable for the hole injection layer to have a small difference in ionization potential in order to lower a hole injection barrier from the first electrode 140. When the injection efficiency of electric charges from the electrode to the hole injection layer is increased, the drive voltage of the organic EL element 100 is lowered so that the injection efficiency of the electric charges is increased.

For the material of the hole injection layer, a high molecular material or a low molecular material is used. Among the high molecular materials, polyethylenedioxythiophene (PEDOT: PSS) doped with polystyrene sulfonic acid (PSS) is often used. Among the low molecular materials, copper phthalocyanine (CuPc) of a phthalocyanine system is widely used.

The hole transport layer has a function to transfer the holes injected by the hole injection layer to the light emitting layer. For the hole transport layer, a triphenylamine derivative, N,N'-Bis(1-naphthyl)-N,N'-Diphenyl-1,1'-biphenyl-4,4'-diamine (NPD), N,N'-Diphenyl-N,N'-Bis[N-phenyl-N-(2-naphtyl)-4'-aminobiphenyl-4-yl]-1,1'-biphenyl-4,4'-diamine (NPTE), 1,1'-bis[(di-4-tolylamino)phenyl]cyclohexane (HTM2), and N,N'-Diphenyl-N,N'-Bis(3-methylphenyl)-1,1'-diphenyl-4,4'-diamine (TPD) or the like may be used, for example.

The thickness of the hole transport layer is within a range of 10 nm to 150 nm, for example. The thinner the layer, the lower the voltage of the organic EL element can be. However, the thickness is generally within a range of 10 nm to 150 nm in view of an interelectrode short circuit problem.

The light emitting layer has a function to provide a field at which the injected electrons and the holes are recombined. For the organic luminescent material, a low molecular material or a high molecular material may be used.

The light emitting layer may be, for example, a metal complex of quinoline derivative such as tris(8-quinolinolate) aluminum complex (Alq₃), bis(8-hydroxy) quinaldine aluminum phenoxide (Alq'20Ph), bis(8-hydroxy) quinaldine aluminum-2,5-dimethylphenoxide (BAlq), mono(2,2,6,6-tetramethyl-3,5-heptanedionate)lithium complex (Liq), mono(8-quinolinolate)sodium complex (Naq), mono(2,2,6,6-tetramethyl-3,5-heptanedionate) lithium complex, mono(2,2,6,6-tetramethyl-3,5-heptanedionate) sodium complex, bis(8-quinolinolate) calcium complex (Caq₂) and the like, or a fluorescent substance such as tetraphenylbutadiene, phenylquinacridone (QD), anthracene, perylene, coronene and the like.

As for the host material, a quinolinolate complex may be used, especially, an aluminum complex having 8-quinolinol or a derivative thereof as a ligand may be used.

The electron transport layer has a function to transport electrons injected from the electrode. For the electron transport layer, for example, a quinolinol aluminum complex (Alq₃), an oxadiazole derivative (for example, 2,5-bis(1-naphthyl)-1,3,4-oxadiazole (END), 2-(4-t-butylphenyl)-5-(4-biphenyl)-1,3,4-oxadiazole (PBD) or the like), a triazole derivative, a bathophenanthroline derivative, a silole derivative or the like may be used.

The electron injection layer may be, for example, made by providing a layer in which alkali metal such as lithium (Li), cesium (Cs) or the like is doped at an interface with the second electrode 160.

### (Second electrode 160)

For the second electrode 160, a metal with a small work function or the alloy thereof is used. The second electrode 160 may be, for example, an alkali metal, an alkaline earth metal, metals in group 3 of the periodic table and the like. The second electrode 160 may be, for example, aluminum (Al), magnesium (Mg), an alloy of these metals and the like.

Further, a co-vapor-deposited film of aluminum (Al) and magnesium silver (MgAg) or a laminated electrode in which aluminum (Al) is vapor-deposited on a thin layer of lithium fluoride (LiF) or lithium oxide (Li₂O) may be used. Further, a laminated layer of calcium (Ca) or barium (Ba) and aluminum (Al) may be used.

### (Method of manufacturing organic LED element of embodiment)

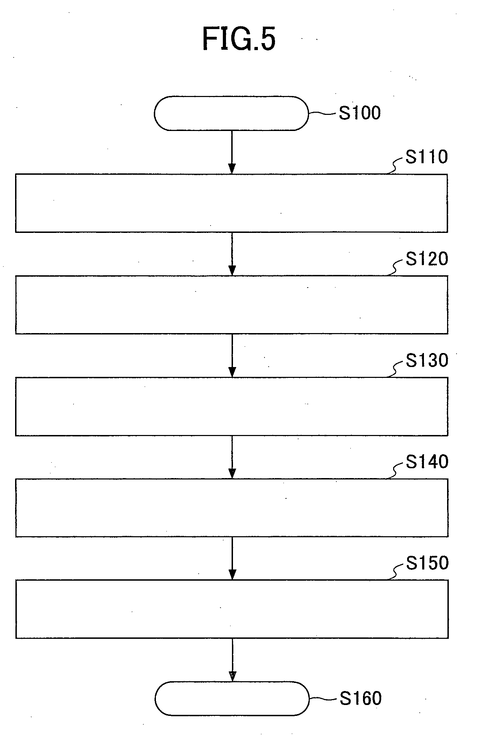

Next, with reference to Fig. 5, an example of a method of manufacturing the organic LED element according to the embodiment is explained. Fig. 5 is a schematic flowchart illustrating a method of manufacturing the organic LED element according to the embodiment.

As shown in Fig. 5, the method of manufacturing the organic LED element according to the embodiment, includes
(a) a step (step S110) in which the light scattering layer is formed on the transparent substrate, the light scattering layer including the base material made of glass and the plurality of scattering substances dispersed in the base material,
(b) a step (step S120) in which the coating layer is provided on the light scattering layer by the wet-coating,
(c) a step (step S130) in which the transparent first electrode is provided on the coating layer,
(d) a step (step S140) in which the organic light emitting layer is provided on the first electrode, and
(e) a step (step S150) in which the second electrode is provided on the organic light emitting layer. Each of the steps is explained in detail in the following.

### (Step S110)

First, the transparent substrate is prepared. As described above, the transparent substrate may be a glass substrate, a plastic substrate or the like.

Then, the light scattering layer in which the scattering substances are dispersed in the glass base material is formed on the transparent substrate. The method of forming the light scattering layer is not particularly limited, but the method of forming the light scattering layer by a "frit paste method" is specifically explained in this embodiment. However, the light scattering layer may be formed by other methods.

In the frit paste method, a paste including a glass material, called a frit paste, is prepared (preparing step), the frit paste is coated at a surface of a substrate to be mounted and patterned (patterning step), and the frit paste is sintered or baked (Sintering step). With these steps, a desired glass film is formed on the substrate to be mounted. Each of the steps is explained in the following.

### (Preparing step)

First, the frit paste including glass powders, resin, solvent and the like is prepared.

The glass powder is made of a material finally forming the base material of the light scattering layer. The composition of the glass powder is not particularly limited as long as desired scattering characteristics can be obtained while being capable of being in a form of the frit paste and sintered. The composition of the glass powder may be, for example, including 20 mol% to 30 mol% of P₂O₅, 3 mol% to 14 mol% of B₂O₃, 10 mol% to 20 mol% of Bi₂O₃, 3 mol% to 15 mol% of TiO₂, 10 mol% to 20 mol% of Nb₂O₅, 5 mol% to 15 mol% of WO₃ where the total amount of Li₂O, Na₂O and K₂O is 10 to 20 mol%, and the total amount of the above components is more than or equal to 90 mol%. Further, the composition of the glass powder may be, including 0 to 30 mol% of SiO₂, 10 to 60 mol% of B₂O₃, 0 to 40 mol% of ZnO, 0 to 40 mol% of Bi₂O₃, 0 to 40 mol% of P₂O₅, 0 to 20 mol% of alkali metal oxide where the total amount of the above components is more than or equal to 90 mol%. The grain diameter of the glass powder is, for example, within a range of 1 µm to 100 µm.

In order to control a thermal expansion characteristic of a finally obtained scattering layer, a predetermined amount of fillers may be added to the glass powder. As for the filler, for example, particles such as zircon, silica, alumina or the like may be used, and the grain diameter may be within a range of 0.1 µm to 20 µm.

For the resin, for example, ethyl cellulose, nitrocellulose, acrylic resin, vinyl acetate, butyral resin, melamine resin, alkyd resin, rosin resin or the like may be used. By adding butyral resin, melamine resin, alkyd resin, or rosin resin, the strength of the frit paste coating layer is improved.

The solvent has a function to dissolve resin and adjust the viscosity. The solvent may be, for example, an ether type solvent (butyl carbitol (BC), butyl carbitol acetate (BCA), dipropylene glycol butyl ether, tripropylene glycol butyl ether, butyl cellosolve acetate), an alcohol type solvent (α-terpineol, pine oil), an ester type solvent (2,2,4-trimethyl-1,3-pentanediol monoisobutyrate), a phthalic acid ester type solvent (dibutyl phthalate (DBP), dimethyl phthalate (DMP), dioctyl phthalate (DOP)) or the like. The solvent mainly used is α-terpineol or 2,2,4-trimethyl-1,3-pentanediol monoisobutyrate. Further, dibutyl phthalate (DBP), dimethyl phthalate (DMP) and dioctyl phthalate (DOP) also function as a plasticizer.

Further, for the frit paste, a surfactant may be added for viscosity adjustment and frit dispersion promotion. Further, a silane coupling agent may be used for surface modification.

Then, the frit paste in which the glass materials are uniformly dispersed is prepared by mixing these materials.

### (Patterning step)

Then, the frit paste prepared by the above described method is coated on the transparent substrate to be patterned. The method of coating and patterning is not particularly limited. For example, the frit paste may be pattern printed on the transparent substrate using a screen printer. Alternatively, doctor blade printing or die coat printing may be used.

Thereafter, the frit paste layer is dried.

### (Sintering step)

Then, the frit paste layer is sintered (or baked). Generally, sintering is performed by two steps. In the first step, the resin in the frit paste layer is decomposed and made to disappear, and in the second step, the glass powders are sintered and softened.

The first step is performed under the atmosphere by retaining the frit paste layer within a temperature range of 200 °C to 400 °C. Note that the process temperature is varied in accordance with the material of the resin included in the frit paste. For example, when the resin is ethyl cellulose, the process temperature may be about 350 °C to 400 °C and when the resin is nitrocellulose, the process temperature may be about 200 °C to 300 °C. The process period is generally about 30 minutes to 1 hour.

The second step is performed under the atmosphere by retaining the frit paste layer within a temperature range of softening temperature of the glass powder included in the frit paste layer ± 30 °C. The process temperature is, for example, within a range of 450 °C to 600 °C. Further, the process period is not particularly limited, but for example, is 30 minutes to 1 hour.

The base material of the light scattering layer is formed after the second step as the glass powder is sintered and softened. Further, by the scattering substances, for example by pores, included in the frit paste layer, the scattering substances uniformly dispersed in the base material can be obtained.

Thereafter, by cooling the transparent substrate, the light scattering layer having a surface whose side surface is moderately inclined with an angle smaller than a right angle is formed.

The thickness of the finally obtained scattering layer may be within a range of 5 µm to 50 µm.

### (Step S120)

Then, the coating layer is provided on the light scattering layer obtained in the above step. Generally, the coating layer is composed of ceramics.

As described above, the coating layer is formed by the wet-coating. The kind of the wet-coating is not particularly limited, but a method of forming the coating layer using sol-gel liquid including organic metal solution and organic metal particles is explained in the following. However, the coating layer may be formed by a wet-coating method other than this.

When forming the coating layer using the sol-gel liquid including organic metal solution and organic metal particles, the coating layer is formed by a step (coating step) of coating the sol-gel liquid on the light scattering layer, a step (drying step) of drying the coated sol-gel layer and a step (heating step) of heating the dried sol-gel layer. Each of the steps is briefly explained in the following.

### (Coating step)

First, the sol-gel liquid is coated on the light scattering layer. The sol-gel liquid includes an organic metal solution and organic metal particles.

The organic metal solution is alkoxide or an organic complex of titanium, niobium, zirconium, tantalum or silicon. In addition to these, the organic metal solution may include a silicon oxide source such as organic silane or the like.

The organic metal particles may include, for example, oligomer or particles of organic titanium, organic niobium, organic zirconium, and/or organic tantalum. The solvent of the sol-gel liquid is not particularly limited, and water and/or organic solvent may be used as the solvent.

The organic metal solution is not limited to the following specific examples, but for example, a composition composed of titanium alkoxide such as titanium tetramethoxide, titanium tetraethoxide, titanium tetranormalpropoxide, titanium tetraisopropoxide, titanium tetranormalbutoxide, titanium tetraisobutoxide, titanium diisopropoxydinormalbutokido, titanium ditertiarybutoxydiisopropoxide, titanium tetratertiarybutoxide, titanium tetrapentoxide, titanium tetrahexoxide, titanium tetraheptoxide, titanium tetraisooctyloxide, titanium tetrastearyl alkoxytitanate or the like, titanium tetracycloalkyloxide such as titanium tetracyclohexoxide or the like, titanium aryloxide such as titanium tetraphenoxide or the like, titanium acylate such as hydroxyl titanium stearate or the like, titanium chelate such as dipropoxytitaniumbis(acetylacetonato), titanium tetraacetylacetonato, titanium di-2-ethylhexoxybis(2-ethyl-3-hydroxyhexoxide), titaniumdiisopropoxybis(ethylacetoacetate), titaniumdiisopropoxybis(triethanolaminato), titanium lactate ammonium salt, titanium lactate or the like, alkoxy zirconium such as zirconium tetranormalpropoxide, zirconium tetranormalbutoxide or the like, zirconium acylate such as zirconium tributoxymonostearate, zirconium chloride compound, aminocarboxylic acid zirconium or the like, zirconium chelate such as zirconium tetraacetylacetonato, zirconium tributoxymonoacetylacetonato, zirconium dibutoxybis(ethylacetoacetate), zirconium tetraacetylacetonato or the like, alkoxysilane group such as tetramethoxy silane, methyltrimethoxy silane, dimethyldimethoxy silane, phenyltrimethoxy silane, diphenyldimethoxy silane, hexyltrimethoxy silane, decyltrimethoxy silane, vinyltrimethoxy silane, 2-(3,4-epoxycyclohexyl)ethyltrimethoxy silane, 3-glycidoxypropylmethyldimethoxy silane, 3-(glycidyloxy)propyltrimethoxy silane, trifluoropropyltrimethoxy silane, p-styryltrimethoxy silane, 3-methacryloxypropylmethyldimethoxy silane, 3-methacryloxypropyltrimethoxy silane, 3-acryloxypropyltrimethoxy silane, N-2-(aminoethyl)-3-aminopropylmethyldimethoxy silane, N-3-(aminoethyl)-3-aminopropyltrimethoxy silane, N-phenyl-3-aminopropyltrimethoxy silane, 3-mercaptpropylmethyldimethoxy silane, 3-mercaptpropyltrimethoxy silane, tetraethoxysilane, methyltriethoxy silane, dimethyldiethoxy silane, phenyltriethoxy silane, diphenyldiethoxy silane, 3-methacryloxypropylmethyldiethoxysilane, 3-methacryloxypropyltriethoxysilane, hexyltriethoxysilane, vinyltriethoxy silane, 3-glycidoxypropylmethyldiethoxy silane, 3-glycidoxypropyltriethoxysilane, N-2-(aminoethyl)-3-aminopropyltriethoxysilane, 3-aminopropyltrimethoxy silane, 3-triethoxysilyl-N-(1,3-dimethyl-butylidene)propylamine, 3-ureidopropyltriethoxy silane, 3-isocyanatepropyltriethoxy silane, tetranormalpropoxy silane, tetraisopropoxy silane, tetranormalbutoxy silane, tetraisobutoxy silane, diisopropoxydinormalbutoxy silane, ditertiarybutoxydiisopropoxy silane, tetratertiarybutoxy silane, tetrapentoxy silane, tetrahexoxysilane, tetraheptyloxy silane, tetraisooctyloxysilane, tetrastearyl alkoxysilane or the like, silazane group such as hexamethyldisilazane or the like and solvent such as alcohol, ether, ketone or hydrocarbon group.

For the organic metal such as alkoxide or chelate compound group of titanium, niobium, zirconium, tantalum or silicon, a compound oligomer of titanium, niobium, zirconium, tantalum or silicon obtained by condensing is preferably used. The method of condensing is not particularly limited, however, it is preferable to react water in alcohol solution. By condensing, generation of cracks during film deposition can be suppressed so that a thick layer can be formed. Further, in particular, by mixing an organic silane compound, generation of cracks during film deposition can be suppressed so that a thick layer can be formed. Further, the refraction index of the film can be also adjusted.

The method of coating the sol-gel liquid is not particularly limited. The sol-gel liquid may be coated on the light scattering layer using a general coated layer forming apparatus (a spin coater, an applicator or the like).

The method of coating the sol-gel liquid is not particularly limited. The sol-gel liquid may be coated on the light scattering layer using a general coated layer forming apparatus (an applicator or the like).

### (Drying step)

Then, the sol-gel liquid coated on the light scattering layer is dried to form a sol-gel layer. The drying condition is not particularly limited. The drying may be performed by, for example, retaining the transparent substrate with the light scattering layer on which the sol-gel liquid is coated at a temperature of 80 °C to 120 °C for about a minute to an hour.

### (Heating step)

Then, the dried sol-gel layer is retained at a high temperature. With this, the organic metal compound in the sol-gel layer is oxidized and bonded as well as the solvent within the sol-gel layer being completely vaporized, decomposited, and/or burned to form a coating layer.

With this, the coating layer composed of a mixture of titania and silica, for example, is formed.

The heating condition is not particularly limited. For example, the retaining temperature may be within a range of 450 °C to 550 °C and the retaining period may be within a range of 10 minutes to 24 hours.

With the above steps, the coating layer is formed.

In the above described coating step, sol-gel liquid is used as a source material of a coating layer. Thus, even if contaminants exist on the light scattering layer, the sol-gel liquid is provided to the areas that become shaded by the contaminants on the light scattering layer. Thus, finally, the continuous coating layer that covers the entirety of the light scattering layer and the contaminants can be formed with the above steps, as illustrated in Fig. 4.

The stacked structure including the transparent substrate, the light scattering layer and the coating layer obtained by the above described steps is referred to as a "translucent substrate". Specifications of the first electrode, the organic light emitting layer, the second electrode and the like vary in accordance with the finally obtained organic LED element. Thus, customarily, there are many cases where the "translucent substrate" is distributed to market as an intermediate product, and the following steps may be omitted.

### (Step S130)

Then the transparent first electrode (anode) is provided on the thus obtained coating layer.

The method of providing the first electrode is not particularly limited but a method of forming a film such as sputtering, vapor deposition, chemical vapor deposition or the like may be used, for example.

As described above, the material of the first electrode may be ITO or the like. Further, the thickness of the first electrode is not particularly limited but may be within a range of 50 nm to 1.0 µm, for example.

The first electrode may be patterned by an etching process or the like. When a material having a resistance against the etching solution that is used in an etching process of the first electrode is used as the material of the coating layer, damage to the light scattering layer when patterning the first electrode can be prevented even when the light scattering layer is composed of a material that does not have a resistance against the etching solution.

### (Step S140)

Then, the organic light emitting layer is provided to cover the first electrode. The method of providing the organic light emitting layer is not particularly limited, but vapor deposition and/or coating may be used, for example.

### (Step S150)

Then the second electrode is provided on the organic light emitting layer. The method of providing the second electrode is not particularly limited but vapor deposition, sputtering, chemical vapor deposition or the like may be used, for example.

With the above methods, the organic LED element 100 as shown in Fig. 3 is manufactured.

Here, the above described method of manufacturing the organic LED element is an example and the organic EL element may be manufactured by other methods.

### [Example]

An example of the embodiment is explained.

Various organic EL elements are manufactured by the following method and characteristics of the elements are evaluated.

### (Manufacturing of various organic EL elements)

A soda lime substrate having the length of 50 mm × the width of 50 mm × the thickness of 0.55 mm was prepared as the transparent substrate. Then, three kinds of translucent substrates are prepared by forming layers on the transparent substrate.

### (First translucent substrate)

The first translucent substrate includes the light scattering layer and the coating layer on the transparent substrate.

The light scattering layer and the coating layer were manufactured by the following method.

### (Formation of light scattering layer)

A source material for the light scattering layer was prepared by the following method.

First, mixed particles having the composition shown in Table 1 were prepared and were dissolved. The dissolution was performed by retaining the mixture at 1050 °C for 1.5 hours and then retaining the mixture at 950 °C for 30 minutes. Thereafter, the dissolved object was casted in a twin-roll process to obtain a flake glass.

**[Table 1]**

| COMPOUND | mol% |
|---|---|
| B₂O₃ | 47.4 |
| Bi₂O₃ | 15.7 |
| ZnO | 32.1 |
| SiO₂ | 1 |
| Al₂O₃ | 3.8 |
| REFRACTION INDEX AT d-RAY n_{d} | 1.84 |
| DENSITY (g/cm³) | 4.87 |
| COEFFICIENT OF THERMAL EXPANSION *α*₅₀₋₃₀₀ at 50 °C to 300 °C (10⁻⁷/K) | 71 |
| GLASS-TRANSITION TEMPERATURE Tg (°C) | 475 |
| SOFTENING POINT Ts (°C) | 574 |

The refraction index of the flake glass was measured using a refractometer (trade name: KRP-2, manufactured by Kalnew Optical Industrial Co., Ltd.). The refraction index "nd" of the flake glass was 1.84 at d-ray (587.56 nm).

Then, the flake glass was pulverized by a planetary ball mill made of zirconia for two hours to obtain a glass powder having a mean grain diameter (d₅₀): grain size at integrated value 50%, unit: µm) of 1 µm to 3 µm.

Next, 15 vol % of silica balls each having diameters of 3 µm was added to 75 g of the glass powder, and kneaded with 25 g of an organic vehicle (prepared by dissolving about 10 mass % ethyl cellulose in α-terpineol or the like) to prepare a glass paste. Further, the glass paste was printed on the soda lime substrate using a screen printer. With this, a scattering layer having two circular patterns each having diameters of 10 mm was formed on the soda lime substrate. After the screen printing, the soda lime substrate was dried at 120 °C for ten minutes.

The soda lime substrate was heated up to 450 °C in 45 minutes, retained for 10 hours at 450 °C, further heated to 575 °C in 12 minutes, retained for 40 minutes at 575 °C, and thereafter, cooled to the room temperature in three hours. The thickness after sintering (or baking) was 15.0 µm. Then, the paste without the silica balls was prepared similarly as the above method to form a covering layer. The thickness of the covering layer was 15.0 µm. With this operation, the light scattering layer with the covering layer was formed on the soda lime substrate.

The thickness of the light scattering layer was 30 µm in total.

### (Formation of coating layer)

The coating layer was formed on the light scattering layer by the following method.

As examples 1 to 12 shown in Table 2, a mixture of predetermined amounts of various organic metal compounds was diluted by solvent capable of retaining stability such as toluene, heptane, 1-butanol, methoxybutanol or the like to obtain liquid having a viscosity appropriate for forming the coating layer. The liquid for forming the coating layer was dropped on the light scattering layer formed on the glass substrate to form a coated layer using a spin coater.

**[Table 2]**

| EXAMPLE | | 1 | 2 | 3 | 4 | 5 | 6 | 7 | 8 | 9 | 10 | 11 | 12 | 13 | 14 |
|---|---|---|---|---|---|---|---|---|---|---|---|---|---|---|---|
| COMPOSITION mass% | titanium tetraisopropoxide | | | 30 | | | | | | | | 100 | | | |
| | titanium tetranormalbutoxide | 40 | 50 | | | | | | | | | | 100 | | |
| | polyhydroxyl titanium stearate | | | | | | | | | | 100 | | | | |
| | titanium diisopropoxybisacetylacetonato | | | 30 | | | | | | | | | | | |
| | titanium tetraacetylacetonato | | | | | | 40 | | | | | | | | |
| | titanium tetraethylacetylacetonato | | | | 40 | 50 | | | | | | | | | |
| | zirconium tetranormalpropoxide | | | | | | | | | | | | | 100 | |
| | zirconium tetranormalbutoxide | | | | | | | | | | | | | | 100 |
| | tetramethoxy silane | | | | | | 30 | | | | | | | | |
| | tetraethoxy silane | | | | | | | | 25 | 20 | | | | | |
| | trimethoxymethyl silane | | | 40 | | | 30 | 75 | 25 | 20 | | | | | |
| | 3-glycidyloxypropyltrimethoxy silane | 60 | 50 | | | | | | | | | | | | |
| | methylhydropolysilazane | | | | 60 | 50 | | | | | | | | | |
| | TiO₂ nano particle | | | | | | | 25 | 50 | 60 | | | | | |
| | TOTAL | 100 | 100 | 100 | 100 | 100 | 100 | 100 | 100 | 100 | 100 | 100 | 100 | 100 | 100 |
| FILM DEPOSITION | CRACK DOES NOT GENERATED AFTER SINTERING WITH THICKNESS OF 150 nm | ○ | ○ | ○ | ○ | ○ | ○ | ○ | ○ | ○ | ○ | × | × | × | × |
| CHEMICAL RESISTANCE | HAVING RESISTANCE AGAINST IMMERSING IN ITO ETCHANT FOR 1 MINUTE | ○ | ○ | ○ | ○ | ○ | ○ | × | × | × | × | × | × | × | × |
| REFRACTION INDEX AFTER SINTERING (nD;587.56nm) | | 1.78 | 1.84 | 1.93 | 1.70 | 1.75 | 1.70 | 1.70 | 1.95 | 2.06 | 1.95 | --- | --- | --- | --- |
| D I FFERENCE IN REFRACTION INDEX BETWEEN FIRST ELECTRODE (nd=1.81) | | 0.03 | 0.03 | 0.12 | 0.11 | 0.06 | 0.11 | 0.11 | 0.14 | 0.25 | 0.14 | --- | --- | --- | --- |

The coated layer was put into a drying machine retained at 120 °C and retained therein for 10 minutes to obtain a dried layer having a thickness of 0.6 µm.

The dried layer was sintered at 475 °C for an hour to obtain a sintered layer with a thickness of 150 nm.

Then, the liquid for forming the coating layer is coated again on the sintered layer, dried and sintered to obtain a coating layer of the two stacked sintered layers with a thickness of 300 nm.

Although it may be relatively difficult to form a thick layer as the sintered layer by the above method because shrinkage at the sintering is large, a layer which can have a thickness of 150 nm without generation of cracks is more preferable as the coating layer. Further, it is more preferable for the coating layer not to be damaged when being immersed in a so-called ITO etchant solution composed by mixture of equal amounts of 45° Baumé ferric chloride (FeCl₃ of more than or equal to 42 mass %) and hydrochloric acid (35 mass % HCl) at 40°C for a minute.

From the above results, it was revealed that examples 1 to 6 are good in film deposition and chemical resistance. On the other hand, it was revealed that examples 7 to 14 are not so good in film deposition and/or chemical resistance.

According to the finding by the inventors, the reason that examples 1 to 6 are good in film deposition and chemical resistance is considered as follows. As shown by the following chemical formula, examples 1 to 6 include the titanium compound or the silicide compound containing alkoxysilane or silazane including at most three reactive functional groups, each of which becomes a Si-O-Si bonding structure by sintering, the titanium compound or the silicide compound containing an organic silicon compound including three or less reactive functional groups, which is one of alkoxy, hydroxy, hydro and amino per Si atom, or the titanium compound or the silicide compound containing an organic silicon compound including three or less reactive functional groups, which is one of alkoxy, hydroxy, hydro and amino per Si atom and at least one or more Si-C bonds.

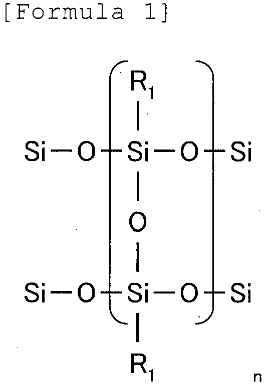

The above first translucent substrate, including the light scattering layer and the coating layer on the transparent substrate, was manufactured by forming the coating layer using liquid having the composition of example 1 in Table 2 for subsequent processes.

### (Second translucent substrate)

A second translucent substrate was prepared to include only the light scattering layer without the coating layer on the transparent substrate.

The light scattering layer was formed similarly to the above described light scattering layer of the first translucent substrate.

### (Third translucent substrate)

A third translucent substrate was prepared to include only the transparent substrate without both the light scattering layer and the coating layer.

### (Formation of first electrode)

Then, the first electrode was formed on the first to third translucent substrates formed by the above described methods by the following method.

The first electrode made of ITO was formed using a batch type magnetron sputtering device. The thickness of the ITO layer was 120 nm.

### (Formation of organic light emitting layer and second electrode)

The organic light emitting layer and the second electrode are formed on the first to third translucent substrates each having the first electrodes by the following method.

First, ultrasonic washing was performed using pure water and IPA, and thereafter, oxygen plasma was irradiated on the translucent substrate to clean the surface.

Next, a hole transport layer, an electron blocking layer, a first light emitting layer, a second light emitting layer, a hole blocking layer, an electron transport layer, and a second electrode were deposited in this order on the first electrode using a vacuum evaporation device.

As the hole transport layer, NHT-49 manufactured by Novaled doped with 3 % of NDP-9 manufactured by Novaled was used. The thickness was varied within a range of 20 nm to 175 nm. As the electron blocking layer, NHT-49 was used. The thickness was 10 nm. As the first light emitting layer, N,N'-bis(1-naphtyl)-N,N'-diphenyl-1,1'-biphenyl-4,4'-diamine, which is an α-NPD derivative, doped with 0.25 % of rubrene (5,6,11,12-tetraphenylnaphthacene) was used. The thickness was 5 nm. As the second light emitting layer, 2-methyl-9,10-di(2-naphthyl)anthracene, which is a MADN derivative, doped with 5 % of p-bis-p-N,N-diphenyl-aminostyryl benzene, which is a DSA derivative, was used. The thickness was 25 nm. As the hole blocking layer, NET-18 manufactured by Novaled was used. The thickness was 10 m. As the electron transport layer, NET-18 doped with 10 % of NDN26 manufactured by Novaled was used. The thickness was 25 nm. As the second electrode, aluminum metal was used. The thickness was 150 nm.

With this, three kinds of organic EL elements in total were obtained. Hereinafter, the organic EL element with the first translucent substrate is referred to as a "first organic EL element", the organic EL element with the second translucent substrate is referred to as a "second organic EL element" and the organic EL element with the third translucent substrate is referred to as a "third organic EL element". The illumination area for the element is 2 mm square.

### (Evaluation on optical characteristics of each organic EL element)

Light extracting efficiencies of the above described organic EL elements were evaluated, respectively.

A measurement evaluation system of an instrument system using an integrating sphere was used for measuring light flux, current and voltage.

Table 3 summarizes measurement results of the light extracting efficiency (%) of each of the organic EL elements. Values in the table express power efficiencies at 1000 cd/m² and the unit of measure is lm/W.

**[Table 3]**

| ELEMENT SAMPLE | TRANSLUCENT SUBSTRATE | THICKNESS OF HOLE TRANSPORT LAYER (nm) | |
|---|---|---|---|
| | | 30 | 170 |
| FIRST ORGANIC EL ELEMENT | FIRST TRANSLUCENT SUBSTRATE (WITH LIGHT SCATTERING LAYER AND WITH COATING LAYER) | 21.2 | 22.1 |
| SECOND ORGANIC EL ELEMENT | SECOND TRANSLUCENT SUBSTRATE (WITH LIGHT SCATTERING LAYER AND WITHOUT COATING LAYER) | 15.5 | 18.3 |
| THIRD ORGANIC EL ELEMENT | THIRD TRANSLUCENT SUBSTRATE (WITHOUT LIGHT SCATTERING LAYER AND WITHOUT COATING LAYER) | 12.4 | 11.3 |

| | | | |
|---|---|---|---|
| (UNIT:%) | | | |

The relationship between the current and the voltage was almost the same for all the organic EL elements.

With this result, it can be understood that the light extracting efficiency is significantly improved for the first organic EL element including both the light scattering layer and the coating layer, regardless of the thickness of the hole transport layer, compared with the second organic EL element without the coating layer and the third organic EL element without both the light scattering layer and the coating layer.

As such, it is confirmed that optical characteristics are improved according to the organic EL element of the embodiment.

The present application is based on and claims the benefit of priority of Japanese Priority Application No. 2011-080716 filed on March 31, 2011, the entire contents of which are hereby incorporated by reference.

### [Numerals]

- 10: organic LED element of related art
- 11: glass plate
- 12: sintered glass layer
- 13: glass substrate
- 14: transparent electrode
- 14a, 14b and 14c: layer portion of transparent electrode
- 15: organic light emitting layer
- 15a, 15b and 15c: layer portion of organic light emitting layer
- 16: second electrode
- 16a, 16b and 16c: layer portion of second electrode
- 21: contaminant
- 25: first side surface
- 26: second side surface
- 29: surface
- 100: organic LED element of embodiment
- 110: transparent substrate
- 120: light scattering layer
- 121: base material
- 124: scattering substances
- 129: surface
- 130: coating layer
- 140: first electrode (anode)
- 150: organic light emitting layer
- 160: second electrode (cathode)
- 170: light extraction surface
- 181: contaminant
- 185, 186: side surface

## Claims

1. An organic LED element comprising:
a transparent substrate;
a light scattering layer formed on the transparent substrate;
a transparent first electrode formed on the light scattering layer;
an organic light emitting layer formed on the first electrode; and
a second electrode formed on the organic light emitting layer,
wherein the light scattering layer includes a base material made of glass, and a plurality of scattering substances dispersed in the base material, and
wherein a coating layer, which is not a molten glass, is provided between the light scattering layer and the first electrode.

2. The organic LED element according to claim 1, wherein the coating layer includes at least one selected from a group including titanium oxide, niobium oxide, zirconium oxide, and tantalum oxide.

3. The organic LED element according to claim 2, wherein the coating layer further includes silicon oxide.

4. The organic LED element according to claim 2, wherein the coating layer is a mixed layer of titanium oxide and silicon oxide.

5. The organic LED element according to any one of claims 1 to 4, wherein the coating layer has a thickness range of 100 nm to 500 nm.

6. The organic LED element according to any one of claims 1 to 5, wherein the scattering substances are bubbles, deposited crystals of the glass composing the base material and/or refractory fillers.

7. A translucent substrate comprising:
a transparent substrate; and
a light scattering layer formed on the transparent substrate,
wherein the light scattering layer includes a base material made of glass, and a plurality of scattering.substances dispersed in the base material, and
wherein a coating layer, which is not a molten glass, is provided on the light scattering layer.

8. The translucent substrate according to claim 7, wherein the coating layer includes at least one selected from a group including titanium oxide, niobium oxide, zirconium oxide, and tantalum oxide.

9. The translucent substrate according to claim 8, wherein the coating layer further includes silicon oxide.

10. The translucent substrate according to claim 8, wherein the coating layer is a mixed layer of titanium oxide and silicon oxide.

11. The translucent substrate according to any one of claims 7 to 10, wherein the coating layer has a thickness range of 100 nm to 500 nm.

12. The translucent substrate according to any one of claims 7 to 11, wherein the scattering substances are bubbles, deposited crystals of the glass composing the base material and/or refractory fillers.

13. A method of manufacturing a translucent substrate including a transparent substrate and a light scattering layer, comprising:
a step (a) of forming the light scattering layer on the transparent substrate, the light scattering layer including a base material made of glass, and a plurality of scattering substances dispersed in the base material; and
a step (b) of providing a coating layer, which is not a molten glass, on the light scattering layer by wet-coating.

14. The method of manufacturing a translucent substrate according to claim 13, wherein the step (b) includes
a step (b1) of providing a sol-gel liquid of an organic metal solution and/or an organic metal particle on the light scattering layer, and
a step (b2) of forming a coating layer by heating the sol-gel liquid.

15. The method of manufacturing a translucent substrate according to claim 14, further comprising a step (b3) of drying the sol-gel liquid between the steps (b1) and (b2).

16. The method of manufacturing a translucent substrate according to any one of claims 13 to 15, wherein the organic metal solution and/or the organic metal particle included in the sol-gel liquid includes at least one element selected from a group including titanium, niobium, zirconium, and tantalum.

17. The method of manufacturing a translucent substrate according to claim 16, wherein the sol-gel liquid further includes silicon oxide.

18. The method of manufacturing a translucent substrate according to any one of claims 13 to 17, wherein the coating layer is a mixed layer of titanium oxide and silicon oxide.

19. The method of manufacturing a translucent substrate according to any one of claims 13 to 18, wherein the step (b2) is performed within a temperature range of 450 °C to 550 °C.

20. A substrate for an organic LED comprising:
a light scattering layer formed on a transparent substrate; and
a coating layer directly formed on the light scattering layer,
wherein the coating layer includes a titanium compound and/or a silicide compound.

21. A substrate for an organic LED comprising:
a light scattering layer formed on a transparent substrate;
a functional layer directly formed on the light scattering layer; and
a coating layer directly formed on the functional layer,
wherein the coating layer includes a titanium compound and/or a silicide compound.

22. The substrate for an organic LED according to claim 21, wherein the functional layer is glass including phosphorus (P).

23. The substrate for an organic LED according to claim 21, wherein the functional layer is glass without phosphorus (P).

24. The substrate for an organic LED according to claim 21, wherein the functional layer is an inorganic layer.

25. The substrate for an organic LED according to claim 21, wherein the functional layer is an organic layer.

26. The substrate for an organic LED according to claim 21, wherein the functional layer is a hybrid layer of an organic material and an inorganic material.

27. The substrate for an organic LED according to any one of claims 20 to 26, wherein the titanium compound and the silicide compound are manufactured from a source material including an alkoxy group.

28. The substrate for an organic LED according to claim 27, wherein the source material includes alkoxysilane or silazane including at most three reactive functional groups, each of which becomes a Si-O-Si bonding structure by sintering.

29. The substrate for an organic LED according to claim 27, wherein the source material includes an organic silicon compound including at most three reactive functional groups, which is one of alkoxy, hydroxy, hydro and amino per Si atom.
